**Europäisches Patentamt**

**European Patent Office**

**Office européen des brevets**

(19)

(11) Veröffentlichungsnummer: **0 222 345**
**B1**

(12) **EUROPÄISCHE PATENTSCHRIFT**

(45) Veröffentlichungstag der Patentschrift: 05.09.90

(51) Int. Cl.⁵: **G 01 R 1/073**

(21) Anmeldenummer: **86115465.6**

(22) Anmeldetag: **07.11.86**

(54) **Verfahren zur Prüfung einer Leiterplatte.**

(30) Priorität: **08.11.85 DE 3539720**

(43) Veröffentlichungstag der Anmeldung:
**20.05.87 Patentblatt 87/21**

(45) Bekanntmachung des Hinweises auf die
Patenterteilung:
**05.09.90 Patentblatt 90/36**

(84) Benannte Vertragsstaaten:
**AT BE CH DE FR GB IT LI LU NL SE**

(56) Entgegenhaltungen:
**EP-A-0 149 776**
**EP-A-0 164 672**

(73) Patentinhaber: **Maelzer, Martin**
**Hagenburger Strasse 26**
**D-3050 Wunstorf (DE)**
(73) Patentinhaber: **Luther, Erich**
**Hagenburger Strasse 26**
**D-3050 Wunstorf (DE)**

(72) Erfinder: **Maelzer, Martin**
**Hagenburger Strasse 26**
**D-3050 Wunstorf (DE)**
Erfinder: **Luther, Erich**
**Hagenburger Strasse 26**
**D-3050 Wunstorf (DE)**
Erfinder: **Dehmel, Rüdiger**
**Ringstrasse 22a**
**D-3050 Wunstorf (DE)**

(74) Vertreter: **Schmidt-Evers, Jürgen, Dipl.-Ing. et al**
**Patentanwälte Dipl.-Ing. H. Mitscherlich Dipl.-**
**Ing. K. Gunschmann Dipl.-Ing. Dr.rer.nat. W.**
**Körber Dipl.-Ing. J. Schmidt-Evers Dipl.-Ing. W.**
**Melzer Steinsdorfstrasse 10**
**D-8000 München 22 (DE)**

Courier Press, Leamington Spa, England.

**Beschreibung**

Der Erfindung betrifft ein Verfahren zur Prüfung einer Leiterplatte und zur Anzeige der ermittelten Fehlerstellen auf dieser Leiterplatte mittels eines Leiterplattenprüfgerätes unter Verwendung eines nach der vorveröffentlichten EP—A—0149776 bekannten Adapters.

Mit dem bekannten Adapter sind im Raster befindliche Prüfkontakte mit im und/oder außer Raster befindlichen Prüfpunkten der zu prüfenden Leiterplatte durch Adapterstifte verbindbar, deren den Prüfpunkten zugewandtes Ende sich konisch verjüngt. Der Adapter weist dazu eine erste und eine zweite Führungsplatte sowie eine zwischen den beiden liegende dritte Führungsplatte auf, die alle drei parallel und mit festem Abstand zueinander angeordnet sind und Führungslöcher für die Adapterstifte enthalten, wobei die erste Führungsplatte im Raster befindliche Führungslöcher und die zweite Führungsplatte im und/oder außer Raster befindliche Führungslöcher aufweist, die mit den Prüfpunkten der zu prüfenden Leiterplatte übereinstimmen, und wobei die dritte Führungsplatte ebenfalls im und/oder außer Raster befindliche Führungslöcher aufweist und die außer Raster befindlichen Führungslöcher der dritten Führungsplatte so gesetzt sind, daß die Adapterstifte einerseits bei senkrechter Einführung in die Führungslöcher der ersten Führungsplatte mit ihrem sich konisch verjüngenden Ende auf jeden Fall noch in diese außer Raster befindlichen Führungslöcher der dritten Führungsplatte treffen und andererseits bei weiterem Einführen durch diese außer Raster befindlichen Führungslöcher der dritten Führungsplatte zwingend in die außer Raster befindlichen Führungslöcher der zweiten Leiterplatte gelenkt werden.

Es liegt nun im Rahmen der üblichen Funktion des Leiterplattenprüfgerätes, daß dieses diejenigen im Raster befindlichen Prüfkontakte feststellt, die fehlerbehafteten im und/oder außer Raster befindlichen Prüfpunkten der zu prüfenden Leiterplatte entsprechen.

Mit dem erfindungsgemäßen Verfahren soll nunmehr eine besonders einfache direkte Anzeige der Fehlerquellen bzw. ein einfaches Aufsuchen der Fehlerquellen auf der fehlerhaften Leiterplatte ermöglicht werden.

Dies wird dadurch erreicht, daß einem Rechner die Daten der Koordinaten aller Kontaktlöcher der zu prüfenden Leiterplatte zugeführt werden, daß mit dem Rechner die Koordinaten der Bohrlöcher für die drei Führungsplatten errechnet werden, daß dann in die drei Führungsplatten die Löcher entsprechend den errechneten Koordinaten gebohrt werden, daß danach aus den drei Führungsplatten der Adapter montiert und die Adapterstifte eingeführt werden, daß der Adapter dann mit der zu prüfenden Leiterplatte dem Leiterplatten-Prüfgerät zugeführt wird, daß darauf die vom Leiterplatten-Prüfgerät ermittelten Daten bzw. Koordinaten derjenigen im Raster befindlichen Prüfkontakte, die fehlerbehafteten im und/oder außer Raster befindlichen Prüfpunkten der zu prüfenden Leiterplatte entsprechen, dem Rechner übermittelt werden, daß mittels des Rechners aufgrund dieser Daten bzw. Koordinaten die Daten bzw. Koordinaten der im und/oder außer Raster befindlichen Prüfpunkte der zu prüfenden Leiterplatte ermittelt werden, und daß diese Daten bzw. Koordinaten mit einem Anzeigegerät angezeigt und die fehlerhaften Prüfpunkte danach auf der zu prüfenden Leiterplatte aufgesucht werden oder daß die fehlerbehafteten Prüfpunkte aufgrund dieser Daten bzw. Koordinaten mittels einer vorzugsweise optisch arbeitenden Fehleranzeige-Vorrichtung direkt markiert werden.

Kernpunkt des erwähnten Verfahrens ist es, daß ein zur Berechnung des Bohrbildes für die Führungsplatten des Adapters eingesetzter Rechner zusätzlich dafür ausgenutzt werden kann, die Daten bzw. Koordinaten der von dem Leiterplatten-Prüfgerät ermittelten Prüfkontakte, die fehlerhaften im und/oder außer Raster befindlichen Prüfpunkten der zu prüfenden Leiterplatte entsprechen, in die Daten bzw. Koordinaten der zuletzt genannten Prüfpunkte umzurechnen, so daß sie entweder auf der Leiterplatte aufgesucht oder direkt optisch markiert werden können. Diese Umrechnung ist erforderlich, weil das Leiterplattenprüfgerät nur die Daten bzw. Koordinaten der erwähnten Prüfkontakte feststellen kann, die auf der Seite der ersten Führungsplatte des Adapters liegen, also im Raster sind. Gewünscht werden jedoch die Daten bzw. Koordinaten der teilweise außer Raster liegenden fehlerbehafteten Prüfpunkte auf der Leiterplatte, die sich auf der Seite der zweiten Führungsplatte des Adapters befinden. Da der Rechner sowohl die Daten bzw. Koordinaten der Führungslöcher der ersten Führungsplatte als auch diejenigen der zweiten Führungsplatte kennt, ist die Umrechnung ohne Schwierigkeiten möglich.

Es ist möglich, die Daten bzw. Koordinaten der fehlerbehafteten Prüfpunkte der zu prüfenden Leiterplatten auf einem Monitor anzuzeigen und die fehlerbehafteten Prüfpunkte dann mittels eines optischen Suchsystems aufzusuchen. Dieses optische Suchsystem kann beispielsweise wie eine übliche Zeichenmaschine funktionieren, bei der die beiden Koordinaten der jeweiligen Stellung des Zeichenkopfes angezeigt werden. Der in diesem Falle mit einem Lupensystem mit Fadenkreuz ausgerüstete Zeichenkopf kann dann in diejenige Stellung gefahren werden, die den ermittelten Koordinaten entspricht.

Es ist aber auch möglich, die Fehlerstellen auf der zu prüfenden Leiterplatte direkt, beispielsweise durch einen Lichtpunkt zu markieren, wobei der Lichtpunkt von einem in zwei Koordinatenrichtungen verfahrbaren Projektor auf die Leiterplatte geworfen wird. Der Steuerung des Projektors werden dann die von dem Rechner ermittelten Daten bzw. Koordinaten zugeführt.

Nachfolgend werden ein Leiterplattenprüfgerät, mehrere Ausführungsformen von in Leiterplattenprüfgeräten verwendeten Adaptern, sowie der Ablauf eines erfindungsgemäßen Verfahrens anhand vereinfachter Zeichnungen beschrieben.

Es zeigt:

Fig. 1 einen Teilschnitt durch ein Gerät zum Prüfen von Leiterplatten, wobei der Teilschnitt senkrecht zum im Gerät aufgenommenen Adapter verläuft;

Fig. 2 einen senkrechten Schnitt durch einen sich auf einem Montagegestell befindlichen Adapter;

Fig. 3 einen Teilschnitt nach der Linie III—III in Fig. 2;

Fig. 4 eine Weiterentwicklung des Adapters nach Fig. 2;

Fig. 5 einen senkrechten Schnitt durch einen Adapter in anderer Ausführungsform;

Fig. 6 einen Ausschnitt des Adapters nach Fig. 5 in der Draufsicht;

Fig. 7 den Adapter nach Fig. 5 in seiner Arbeitsstellung;

Fig. 8 einen senkrechten Schnitt durch einen Adapter in weiterer Ausführungsform;

Fig. 9 einen schematisierten Teilausschnitt aus einem aus drei Führungsplatten bestehenden Adapter mit besonderer Dimensionierung der Führungslöcher der dritten Führungsplatte;

Fig. 10 eine graphische Darstellung, die den Ablauf eines Verfahrens zur Feststellung und Anzeige von Fehlerstellen auf einer zu prüfenden Leiterplatte zeigt.

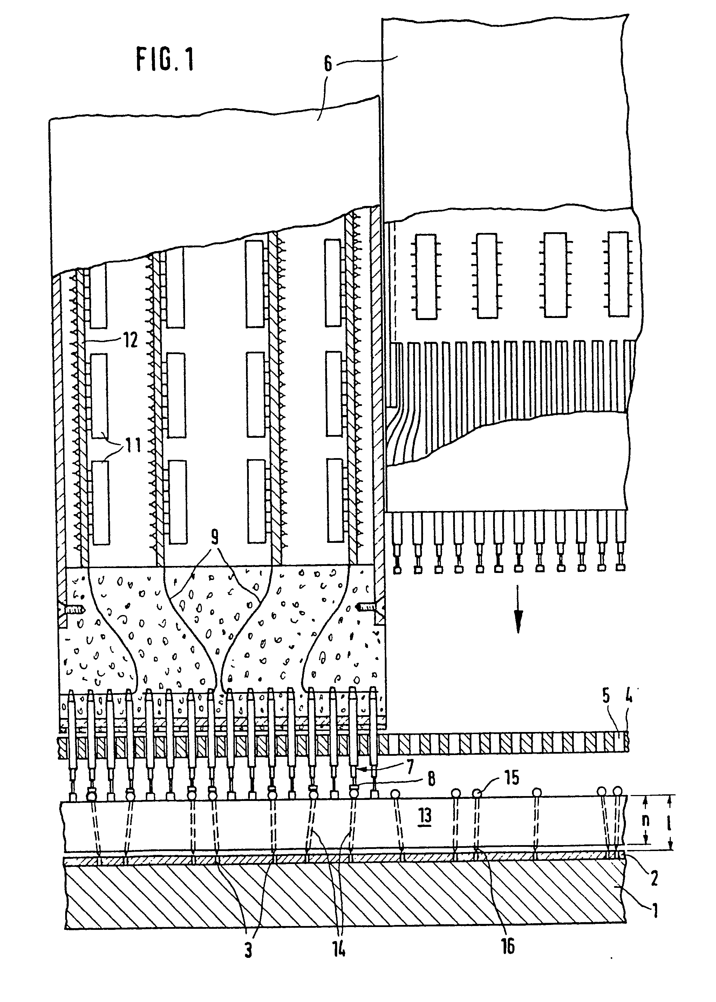

In der Fig. 1 ist eine Aufnahmeplatte des im ganzen nicht dargestellten Gerätes zum Prüfen von Leiterplatten mit 1 bezeichnet. Auf dieser Aufnahmeplatte 1 befindet sich eine Leiterplatte 2 mit Prüfpunkten 3. Oberhalb der zu prüfenden Leiterplatte 2 befinden sich eine Rasterlochplatte 4, deren Löcher 5 im Raster angeordnet sind, und zwei in Richtung auf die Leiterplatte 2 und zurück bewegliche Moduln 6, die an ihren unteren Stirnseiten mit Prüfkontakten 7 in Form von Stiften versehen sind, welche in der herabgefahrenen Position eines Moduls 6 die Löcher 5 in der Rasterlochplatte 4 durchgreifen. Die Prüfkontakte 7 tragen teleskopisch ein- und ausfahrbare Prüfkontaktköpfe 8, die in Richtung auf ihre äußere Endstellung durch eine nicht dargestellte Feder vorgespannt sind.

Die Prüfkontakte 7 sind in den Moduln 6 durch Vergießen befestigt und stehen durch elektrische Leitungen 9 mit IC-Chips 11 tragenden Leiterplatten 12 in Verbindung, die innerhalb der Moduln 6 angeordnet sind und in ihrer Gesamtheit mit den Leiterplatten 12, den IC-Chips 11 und gegebenenfalls weiteren Bauelementen eine den Prüfkontakten 7 zugeordnete Teilschalter-Matrix bilden.

Auf der Leiterplatte 2 befindet sich ein Rasteranpassungsadapter 13, der eine Vielzahl ihn durchfassender Adapterstifte 14 aufweist, die die im Raster angeordneten Prüfkontakte 7 mit den außer Raster angeordneten Prüfpunkten 3 verbinden. Die Adapterstifte 14 liegen deshalb nicht in der jeweiligen Flucht mit den Prüfkontakten, sondern erstrecken sich schräg durch den Adapter 13, wobei sie mit beiden Enden aus dem Adapter hervorragen und gegenüber der Ober- und Unterseite erhabene Kontaktstellen bilden.

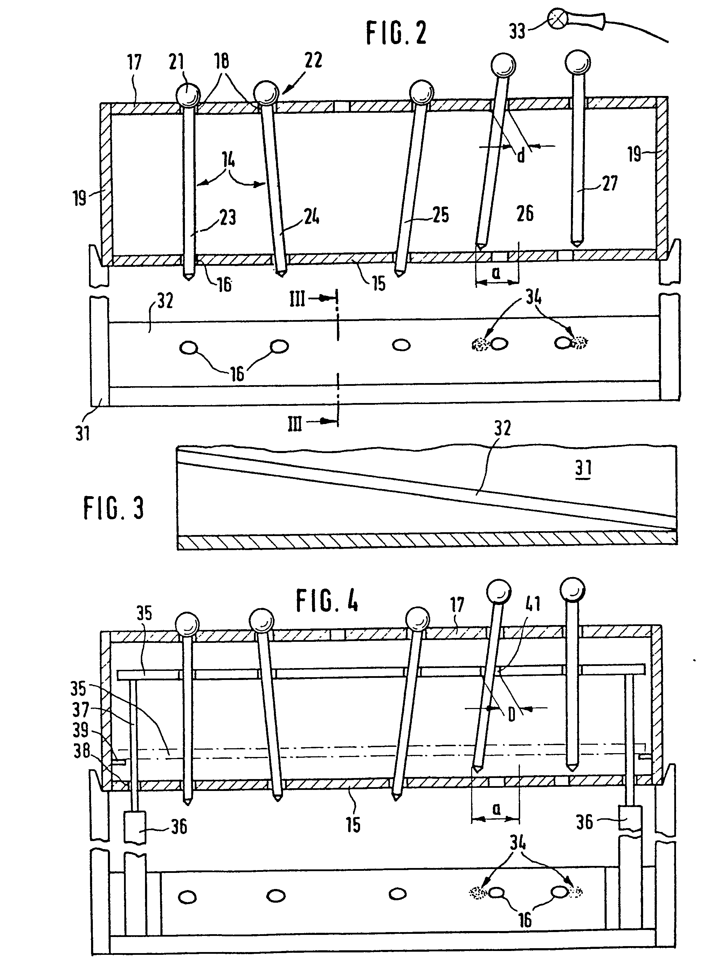

Aus der Fig. 2 ist der Aufbau des Adapters 13 zu erkennen. Der Adapter 13 besteht aus einer unteren Führungsplatte 15 mit im Muster der Prüfpunkte der in Fig. 2 nicht dargestellten, zu prüfenden Leiterplatte 2 angeordneten Führungslöchern 16 und einer im Abstand oberhalb, sich parallel zu dieser erstreckenden oberen Führungsplatte 17, mit im Raster angeordneten Führungslöchern 18 für die Adapterstifte 14. Die Führungsplatte 15 und die Führungsplatte 17 bilden mit stirnseitig an ihnen befestigten Stirnplatten 19 eine Kastenform.

Die Adapterstifte 14 sind von oben durch die Führungslöcher 16, 18 einführbar und sie weisen an ihren oberen Enden Kugelköpfe 21 auf, die in der vollends eingeführten Stellung auf den Rändern 22 der Führungslöcher 18 aufliegen. Es sind fünf Adapterstifte 23 bis 27 dargestellt, von denen die Adapterstifte 23 bis 25 vollends eingeführt sind, während die Adapterstifte 26 und 27 auf der Führungsplatte 15 aufstehen. Während die Führungslöcher 16, 18 für die Adapterstifte 23 und 26 miteinander fluchten, also im Raster liegen, fluchten die Führungslöcher 16, 18 für die Adapterstifte 24, 25 und 27 nicht miteinander, weil diese Führungslöcher in der Führungsplatte 15 sich außer Raster befinden, wodurch eine Schrägstellung der vollends eingeführten Adapterstifte 24, 25 und 27 bedingt ist.

Der Adapter 13 befindet sich auf einem Montagegestell 31 zwecks Einführung der Adapterstifte 23 bis 27, die von Hand eingeführt werden. Unterhalb der Führungsplatte 15 ist im Montagegestell 31 ein Spiegel 32 befestigt, der zur Vorderseite des Adapters 13, d.h. zu der Seite, an der die Bedienungsperson steht, geneigt ist. Es ist eine andeutungsweise dargestellte und mit 33 bezeichnete Handlampe vorhanden, die sich oberhalb der Führungsplatte 17 befindet und beispielsweise durch eine Hand der Bedienungsperson gehalten wird. Die Führungsplatte 17 besteht aus einem Kunststoff, der zwar nicht durchsichtig ist, jedoch eine bestimmte Menge Licht durchläßt, so daß die Führungsplatte 15 auch noch von den Lichtstrahlen der Handlampe 33 beleuchtet wird. Da die Führungsplatte 15 ebenfalls aus einem Material besteht, das geringfügig lichtdurchlässig ist, ist der von den Adapterstiften 26, 27 auf die Führungsplatte 15 geworfene Schatten von unten sichtbar. Deshalb zeichnen sich nicht nur die Führungslöcher 16 der Führungsplatte 15, sondern auch die mit 34 bezeichneten Schatten auf dem Spiegel 32 ab. Die Bedienungsperson kann aufgrund dieser Schattenabbildung erkennen, auf welcher Seite des betreffenden Führungsloches 16 die betreffende Adapterstiftspitze sich befindet. Durch entsprechende Lenkbewegungen der Adapterstifte 26, 27, die durch manuellen Eingriff an den Kugelköpfen 21 herbeigeführt werden, lassen sich die Adapterstiftspitzen gezielt in die zugehörigen Führungslöcher 16 einführen.

Bei dem Ausführungsbeispiel gemäß Fig. 2 ist das mit a bezeichnete Auslenkmaß durch den Durchmesser d der Führungslöcher 18 bestimmt, die mit gewissem Bewegungsspiel von den Adapterstiften 14 durchfaßt werden.

Beim zweiten Ausführungsbeispiel gemäß Fig. 4 ist zwischen der Führungsplatte 15 und der Führungsplatte 17 parallel zu diesen eine mittlere Führungsplatte 35 angeordnet, die mit Hilfe von zwei Kolbenzylindern 36, deren Kolbenstangen 37 die Führungsplatte 15 in Löchern 38 durchfassen, vertikal verstellbar ist, und zwar zwischen einer unteren, strichpunktiert dargestellten Position, die durch Anschläge 39 begrenzt ist, und einer oberen, mit durchgezogenen Linien dargestellten Position. Die mittlere Führungsplatte 35 weist Führungslöcher 41 auf, deren Durchmesser D größer bemessen ist, als der Durchmesser d der Adapterstifte 14. Das Auslenkmaß a wird in diesem Falle durch die Größe der Führungslöcher 41 bestimmt. Durch das Verschieben der mittleren Führungsplatte 35 kann der allseitige Bewegungsspielraum für die Adapterstifte 14 und somit das Auslenkmaß a verändert werden, wenn die Adapterstifte 14 sich oberhalb der Führungsplatte 15 befinden. In der unteren Position der Platte 35 ist das Auslenkmaß a kleiner als in der oberen Position.

Wenn immer gleiche Rastergrößen vorliegen, kann es auch vorteilhaft sein, eine mittlere Platte 35 etwa in der in Fig. 4 strichpunktiert oder durchgezogen dargestellten Position starr anzuordnen.

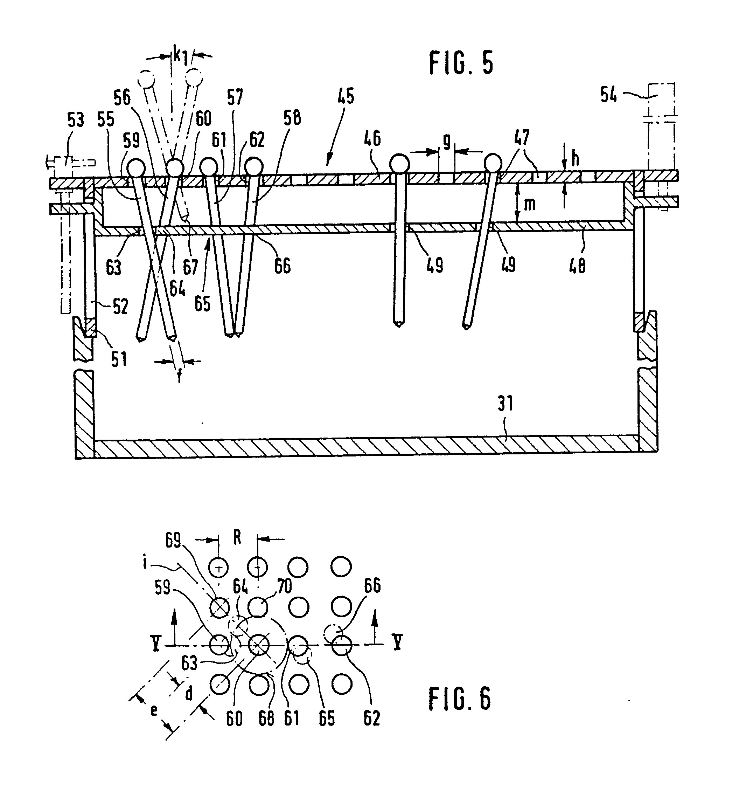

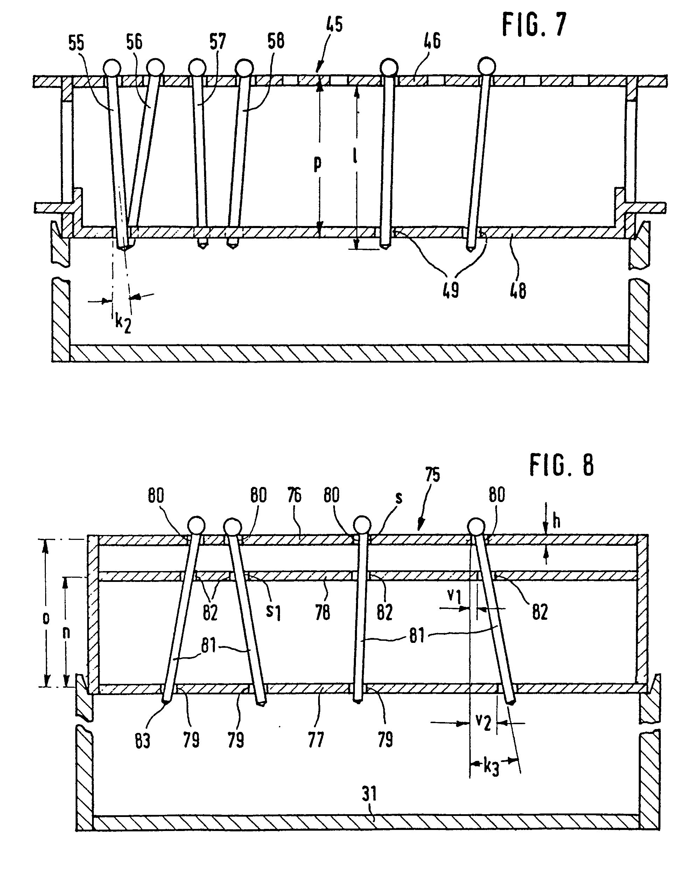

Bei der Ausführungsform gemäß Figuren 5 bis 7 hat der hier mit 45 bezeichnete Adapter ebenfalls Kastenbauweise. Er besteht aus einer ersten Führungsplatte 46 mit Führungslöchern 47 an allen Rasterpunkten und einer zweiten Führungsplatte 48 mit Führungslöchern 49, im Muster der Prüfpunkte der zu prüfenden Leiterplatte. Die erste Führungsplatte 47 ist durchsichtig und besteht in bevorzugter Ausführungsform aus Plexiglas. Die zweite Führungsplatte 48 braucht nicht durchsichtig zu sein und besteht in bevorzugter Ausführungsform aus einem glasfaserverstärkten Kunststoff auf Epoxydharz-Basis, der in der Fachsprache mit EPG bezeichnet wird. In den die Führungsplatten 46, 48 miteinander verbindenden Stirnplatten 51 sind Führungen 52 in Form von Führungsschlitzen ausgebildet, in denen die zweite Führungsplatte 48 zwecks Abstandsveränderung zwischen den Führungsplatten 46, 48 vertikal zwischen einer in Fig. 5 dargestellten Montageposition und einer in Fig. 7 dargestellten Arbeitsposition verstellbar ist. Der Verstellung der zweiten Führungsplatte 48 kann ein Mechanismus dienen, der andeutungsweise in Fig. 5 als Spindeltrieb 53 oder Zylinder-Kolbenantrieb 54 dargestellt ist.

Von den vorhandenen Adapterstiften sind vier Stück mit 55 bis 58 bezeichnet und weiter unten im besonderen beschrieben.

Fig. 5 zeigt die Führungsplatten 46, 48 und die Adapterstifte 55 bis 58 in einem Schnitt längs der Linie V—V in Fig. 6, die einen entsprechenden Ausschnitt der Fig. 5 in Draufsicht zeigt. Die Adapterstifte 55 bis 58 sind in der Montagestellung der Führungsplatte 48 von oben durch die mit 59 bis 62 bezeichneten Führungslöcher in der ersten Führungsplatte 46 und die mit 63 bis 66 bezeichneten Führungslöcher in der zweiten Führungsplatte 48 gesteckt. Von den Führungslöchern in der zweiten Führungsplatte 48 ist das mit 64 bezeichnete in einem maximalen Abstand d vom ihm zugeordneten Rasterpunkt, nämlich dem Führungsloch 60 entfernt. Die Führungslöcher 63, 65 und 66 in der zweiten Führungsplatte 48 haben einen geringeren Abstand von den ihnen zugeordneten Rasterpunkten, nämlich Führungslöcher 59, 61 und 62 in der ersten Führungsplatte 46. Der Abstand d beträgt die Hälfte des Diagonalmaßes e von den im Quadrat angeordneten Führungslöchern 47 in der ersten Führungsplatte 46, deren Rastermaß mit R bezeichnet ist. Die Durchmesser f der Adapterstifte, die Durchmesser g der Führungslöcher 47 in der ersten Führungsplatte 46 und die Dicke h der ersten Führungsplatte 46 sind aufeinander abgestimmt und zwar derart, daß die Spitzen 67 der Adapterstifte 55 einen Taumelkreis 68 beschreiben, wenn ein mit seiner Spitze 67 auf der zweiten Führungsplatte 48 aufliegender Adapterstift im Sinne einer Taumelbewegung bewegt wird, wie es in Fig. 5 beispielshaft strichpunktiert angedeutet ist. Die vorbeschriebenen Abmessungen sind so aufeinander abgestimmt, daß der maximale Radius der Taumelkreises 68 der Hälfte des Diagonalmaßes e entspricht und somit dem Abstand d.

Das Führungsloch 64 in der zweiten Führungsplatte 48 weist die Besonderheit auf, daß es auf der Diagonalen i liegt. Infolgedessen hat es einen gleichen Abstand d von den mit 59, 60 und 69, 70 bezeichneten Führungslöchern. Das heißt, der Adapterstift 56, der durch das Führungsloch 60 in das Führungsloch 64 aufgrund der vorgenannten Abmessungen gerade noch etwas schwergängig einschiebbar ist, könnte auch von einem jeden der Führungslöcher 59 und 69 und 70 ebenfalls gerade noch schwergängig in das Führungsloch 64 eingeführt werden. Die Bestückung von solchen Löchern 64 in der zweiten Führungsplatte 48, die im Schnittpunkt von Diagonalen i liegen, die durch im Quadrat angeordnete Führungslöcher 59, 60, 69, 70 gehen, ist somit 4-fach unbestimmt. Dieser Schwierigkeit wird dadurch Rechnung getragen, daß der Prüfautomat in der Lage ist, die im Adapter 45 vorhandene Anordnung der Adapterstifte zu lernen und sich danach neu zu programmieren. Der Stift-Auslenkwinkel, den die Adapterstifte gegenüber der Senkrechten einnehmen, ist in der Montageposition gemäß Fig. 5 unabhängig von seiner Größe mit $k_1$ bezeichnet. Durch das Verschieben der zweiten Führungsplatte 48 in die in Fig. 7 dargestellte Arbeitsstellung verringern sich die Stift-Auslenkwinkel. Die verringerten Winkel sind in Fig. 7 mit $k_2$ bezeichnet. Hierdurch wird die Leichtgängigkeit der Adapterstifte und zwar insbesondere der Adapterstifte, die in Führungslöchern 64 eingesteckt sind, die im Schnittpunkt von Diagonalen i liegen gewährleistet. Eine gegenseitige Berührung von Adapterstiften 55 bis 58 ist durch das Auseinanderziehen der Führungsplatten 46, 48 ausgeschlossen, weil die Adapterstifte 55 bis 58 sich dabei voneinander entfernen.

Zur vorbeschriebenen Ausführungsform werden noch folgende Bemessungsangaben gemacht:

Dicke h der ersten Führungsplatte 46=1,5 mm

Dicke I der zweiten Führungsplatte 48=1,5 mm

Durchmesser der Führungslöcher in der ersten und zweiten Führungsplatte 46, 48=1,7 mm

Abstand m der Führungsplatten 46, 48 in der Montageposition=3,5 mm,

Durchmesser der Adapterstifte=1,35 mm,

Rasterabstand R der Führungslöcher 47 in der ersten Führungsplatte=2,54 mm.

Bei der weiteren Ausführungsform gemäß Figur 8 weist der hier mit 75 bezeichnete Adapter eine obere erste Führungsplatte 76, eine untere zweite Führungsplatte 77 und eine zwischen diesen angeordnete dritte Führungsplatte 78 auf. Wie schon bei den vorbeschriebenen Ausführungsformen sind auch hier die Führungsplatten 76 bis 78 parallel zueinander angeordnet. Im Gegensatz zur Ausführungsform gemäß Fig. 4 ist hier die dritte Führungsplatte 78 starr angeordnet. Sie könnte zwar abstandsveränderlich sein, jedoch nur zum Zweck ihrer grundsätzlichen Positionierung. Eine Abstandsveränderung bei jeder Bestückung ist nicht vorgesehen.

Der Adapter 75 dieser Ausführungsform ist zu 100% reproduzierbar. Das bedeutet, daß die Bestückung von außerhalb des Rasters liegenden Führungslöchern 79 in der zweiten Führungsplatte 77 nicht unbestimmt sein darf. Mit anderen Worten, jedem Führungsloch 79 in der zweiten Platte 77 ist für die Bestückung ein ganz bestimmtes Führungsloch 80 in der ersten Führungsplatte 76 zugeordnet. Die Führungslöcher 80 in der ersten Führungsplatte 76 sind im Raster angeordnet. Im Gegensatz zur Ausführungsform gemäß Figuren 5 bis 7 jedoch nicht an allen Rasterpunkten, sondern nur an denjenigen, die zur Bestückung des speziellen Adapters 75 Adapterstifte 81 aufnehmen sollen. Die dritte Führungsplatte 78 ist mit Führungslöchern 82 versehen, die im und außer Raster liegen können.

Die außer Raster liegenden Führungslöcher 82 in der dritten Führungsplatte 78 sind jedoch gegenüber den nächstliegenden im Raster befindlichen Führungslöchern 80 der ersten Führungsplatte 76 weniger weit versetzt ($v_1$) als die entsprechenden Führungslöcher 79 in der zweiten Führungsplatte 77 ($v_2$). Der Versatz $v_1$ der außer Raster liegenden Führungslöcher 82 in der dritten Führungsplatte 78 ist so gewählt, daß—wenn der Versatz $v_1$ ein maximaler ist—die insbesondere kegelförmige Spitze 83 der Adapterstifte 81 in jedem Fall noch in die Führungslöcher 79 der zweiten Führungsplatte 77 eintaucht, unabhängig davon, unter welchem Stift-Auslenkwinkel $k_3$ die Adapterstifte 81 in der ersten Führungsplatte 76 eingesteckt sind. Der Versatz $v_1$ der außer Raster befindlichen Führungslöcher 82 in der dritten Führungsplatte 78 ist in Kenntnis des Versatzes $v_2$ der außer Raster befindlichen Führungslöcher 79 in der zweiten Führungsplatte 77 bestimmt, beispielsweise durch einen Computer ausgerechnet.

In vergleichbarer Weise wie bei der Ausführungsform gemäß Figur 5 sind auch bei der Ausführungsform gemäß Fig. 8 die Dicke h der ersten Führungsplatte 76 und das Bewegungsspiel s der Adapterstifte 81 in den Führungslöchern 80 sowie das Bewegungsspiel $s_1$ in den Führungslöchern 82 der dritten Führungsplatte 78 so aufeinander abgestimmt, daß die ggf. angespitzten Spitzen 83 der Adapterstifte 81 in die Führungslöcher 82 beim Einstecken eintauchen.

Zum Ausführungsbeispiel nach Figur 8 werden folgende Bemessungsgrößen angegeben:

Dicke jeder der drei Führungsplatten 76 bis 78=1,7 mm

Durchmesser aller Führungslöcher 79, 80, 82=1,7 mm

Durchmesser der Adapterstifte 81=1,35 mm die dritte Führungsplatte 78 hat einen Abstand n zur zweiten Führungsplatte 77, der etwa 80% vom Abstand o zwischen der ersten Führungsplatte (76) und der zweiten Führungsplatte (77) beträgt.

Bei allen Ausführungsformen haben die Adapterstifte einen zylindrischen Schaft, einen Kugelkopf und eine bevorzugt kegelförmige Spitze. Die Stiftlänge 1 ist etwa um die Größe des Kugelkopfes größer bemessen als die Querabmessung p des Adapters.

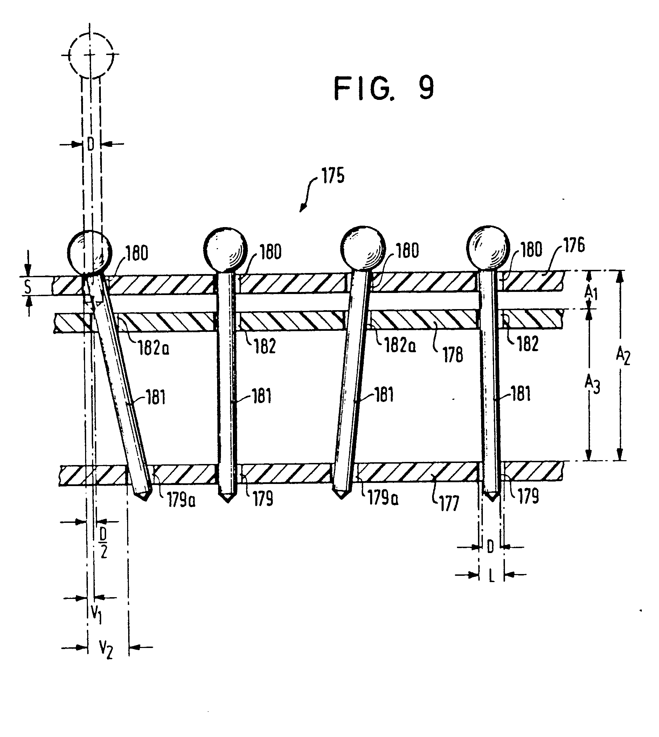

Fig. 9 zeigt ebenfalls einen Adapter, bestehend aus einer ersten Führungsplatte 176, einer zweiten Führungsplatte 177 und einer dritten dazwischen angeordneten Führungsplatte 178. In der ersten Führungsplatte 176 sind im Raster befindliche Löcher 180. In der zweiten Führungsplatte 177 sind ebenfalls im Raster befindliche Führungsfläche 179 sowie außer Raster befindliche Führungslöcher 179a. Die dritte Führungsplatte 178 hat ebenfalls im Raster befindliche Führungslöcher 182 sowie außer Raster befindliche Führungslöcher 182a. Der Versatz der außer Raster befindlichen Führungslöcher 182a in der dritten Führungsplatte gegenüber den entsprechenden Führungslöchern 180 in der ersten Führungsplatte 176 ist hier so gewählt, daß bei senkrechter Einführung eines Adapterstiftes 181 in ein Führungsloch 180 der ersten Führungsplatte 176 auf jeden gewährleistet ist, daß die konische Spitze des Adapterstiftes 181 noch in das entsprechende außer Raster befindliche Führungsloch 182a der dritten Führungsplatte 178 trifft, und andererseits—wenn der Adapterstift 189 durch das Führungsloch 182 weitergeführt wird—dieser Adapterstift 181 zwangsläufig in das entsprechende außer Raster befindliche Führungsloch 179a geleitet wird. Auf diese Weise wird insbesondere bei Anwendung eines automatischen Ladesystems gemäß DE—A—33 40 184 eine praktisch 100%-ige Ausbeute beim Laden innerhalb kürzester Zeit gewährleistet. Wichtig ist hier, daß die Adapterstifte 181 definiert stets senkrecht in die Führungslöcher 180 der ersten Führungsplatte eingeführt werden können, und zwar unabhängig davon, ob die Führungslöcher in der zweiten Führungsplatte 177 im Raster sind oder außer Raster.

Die Position der Führungslöcher 180 der ersten Führungsplatte 176 sind durch das Raster vorgegeben. Die Position der Führungslöcher 179, 179a in der zweiten Führungsplatte 177 ist durch das Lochbild der zu prüfenden Leiterplatte vorgegeben. Der Versatz der Führungslöcher 182a in der dritten Führungsplatte 178 kann unter Berücksichtigung der vorgenannten Bedingungen und Positionsdaten berechnet werden, wozu sich insbesondere ein Computer (Rechner) eignet. Dazu müssen der Plattendurchmesser S, der Stiftdurchmesser D, der Lochmesser L sowie die Abstände der Führungsplatten $A_1$, $A_2$ und $A_3$ so gewählt werden, daß die oben erwähnte gewünschte Bedingung stets realisiert werden kann, d.h. auch dann, wenn der Versatz $V_2$ zwischen einem Führungsloch 180 in der ersten Führungsplatte 176 und einem Führungsloch 179a in der zweiten Führungsplatte 177 im Hinblick auf die Reproduzierbarkeit eines Adapter-Ladungsbildes ein Maximum ist.

In Fig. 9 erkennt man insbesondere bei dem linken Adapterstift 181, daß der halbe Durchmesser des Adapterstiftes D/2 größer als der Versatz $V_1$ zwischen dem Führungsloch 180 der ersten Führungsplatte 176 und dem Führungsloch 182a in der dritten Führungsplatte 178 ist. Dadurch wird gewährleistet, daß der Adapterstift 181 mit seiner Spitze beim senkrechten Einführen (gezeichnet in gestrichelten Linien) noch in den Durchmesserbereich des Führungsloches 182a der dritten Führungsplatte 178 trifft, dann umgelenkt und so weitergeführt wird, daß er schließlich zwangsläufig in das Führungsloch 179a der zweiten Führungsplatte 177 trifft.

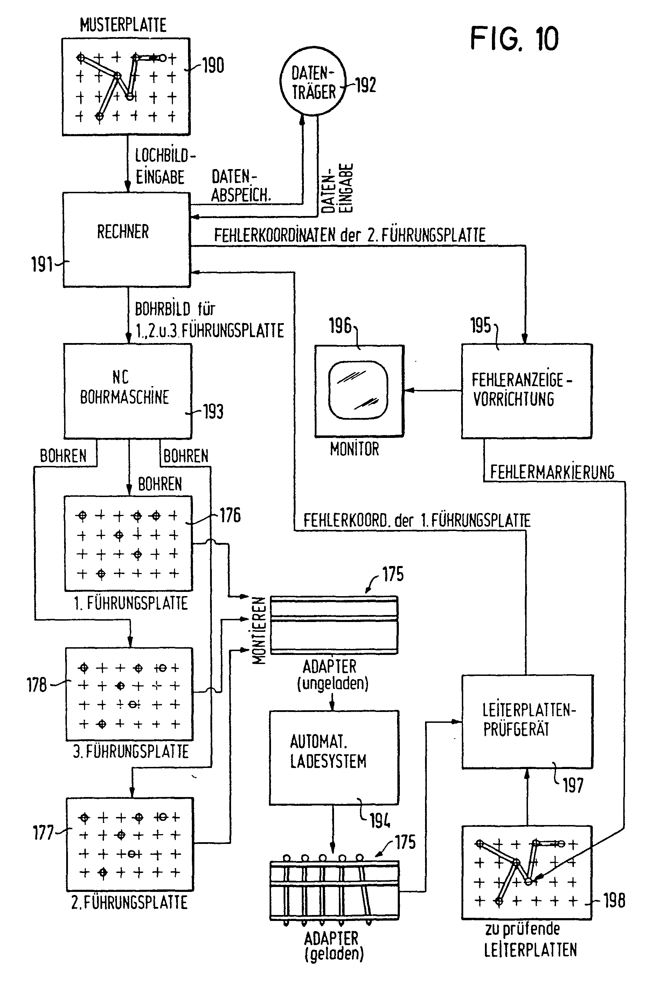

Der in Fig. 10 dargestellte Verfahrensablauf zur Anzeige von Fehlerstellen auf einer zu prüfenden Leiterplatte ist wie folgt: Aufgrund einer einer zu prüfenden Leiterplatte 198 entsprechenden Musterplatte 190 wird in einen Rechner 191 ein Lochbild eingegeben. Die dem Lochbild entsprechenden Daten können auf einem Datenträger, beispielsweise einer Diskette 192 abgespeichert werden. Es ist ebenso möglich, die Daten wieder von dem Datenträger 192 abzurufen und in den Rechner 191 einzugeben. Der Rechner 191 rechnet nun das Bohrbild für die Löcher der Führungsplatten des Adapters gemäß Fig. 9 aus. Die Daten bzw. Koordinaten für dieses Bohrbild werden in eine NC-Bohrmaschine 193 eingegeben, mittels welcher die drei Führungsplatten 176, 177, und 178 gebohrt werden. Nach dem Bohren werden die Führungsplatten zu dem (noch ungeladenen) Adapter 175 montiert. Dieser wird dann in einer automatischen Ladevorrichtung 194 gemäß DE—A—33 40 184 eingesetzt. Der automatischen Ladevorrichtung 194 kann der mit Adapterstiften geladene Adapter 175 entnommen werden. Dieser geladene Adapter 175 wird dann einem Leiterplattenprüfgerät 197 zusammen mit der zu prüfenden Leiterplatte 198 zugeführt.

Das Leiterplattenprüfgerät ermittelt die Daten bzw. Koordinaten derjenigen Prüfkontakte, die an den Kugelköpfen der Adapterstifte anliegen. Die Prüfkontakte liegen auf der Seite der ersten Führungsplatte 176, also alle im Raster. Über die Adapterstifte stehen diese Prüfkontakte mit fehlerbehafteten Löchern der zu prüfenden Leiterplatte 198 in Verbindung. Angezeigt werden sollen die fehlerbehafteten Löcher der zu prüfenden Leiterplatte 198. Diese aber sind teilweise außer Raster, d.h. sie liegen auf der Seite der zweiten Führungsplatte 177. Um nun die Daten bzw. Koordinaten der fehlerbehafteten Löcher auf der zu prüfenden Leiterplatte zu ermitteln, werden die von dem Leiterplattenprüfgerät 197 ermittelten Daten bzw. Koordinaten der im Raster befindlichen Prüfkontakte wiederum dem Rechner 191 zugeführt. Dieser kennt aufgrund der Rechnungsdaten für die Bohrbilder der drei Führungsplatten den Zusammenhang zwischen den Daten bzw. Koordinaten der fehlerbehafteten Prüfpunkte (Löcher) auf der zu prüfenden Leiterplatte einerseits und den Daten bzw. Koordinaten der Prüfkontakte des Leiterplattenprüfgerätes 197 andererseits. Der Rechner 191 gibt dementsprechend an eine Fehleranzeigevorrichtung 195 die Daten bzw. Koordinaten der fehlerbehafteten Prüfpunkte der zu prüfenden Leiterplatte 198 ab, die den Fehlerkoordinaten bzw. -daten der Löcher in der zweiten Führungsplatte 177 entsprechen. Diese Daten bzw. Koordinaten werden auf einem Monitor 196 angezeigt und können für eine Bedienungsperson unter Verwendung eines optischen Suchgerätes mit Koordinatenanzeige dazu verwendet werden, die fehlerbehafteten Prüfpunkte auf der zu prüfenden Leiterplatte 198 aufzufinden. Es ist aber auch möglich, die Fehleranzeigevorrichtung 195 so zu gestalten, daß sie fehlerbehafteten Prüfpunkte bzw. Löcher auf der zu prüfenden Leiterplatte 198 direkt anzeigt, beispielsweise mittels eines Lichtpunktes, der von einem in zwei Koordinatenrichtungen verfahrbaren Projektorkopf erzeugt wird.

**Patentanspruch**

Verfahren zur Prüfung einer Leiterplatte (198) und zur Anzeige der ermittelten Fehlerstellen auf dieser Leiterplatte (198) mittels eines Leiterplattenprüfgerätes (197) unter Verwendung eines Adapters (175), mit welchem im Raster befindliche Prüfkontakte mit im und/oder außer Raster befindlichen Prüfpunkten der zu prüfenden Leiterplatte durch Adapterstifte verbindbar sind, deren den Prüfpunkten zugewandtes Ende sich konisch verjüngt, welcher Adapter eine erste und eine zweite Führungsplatte sowie eine zwischen beiden liegende dritte Führungsplatte aufweist, die alle drei parallel und mit festem Abstand zueinander angeordnet sind und Führungslöcher für die Adapterstifte enthalten, wobei die erste Führungsplatte im Raster befindliche Führungslöcher und die zweite Führungsplatte im und/oder außer Raster befindliche Führungslöcher aufweist, die mit den Prüfpunkten der zu prüfenden Leiterplatte übereinstimmen, und wobei die dritte Führungsplatte ebenfalls im und/oder außer Raster befindliche Führungslöcher aufweist und die außer Raster befindlichen Führungslöcher (182a) der dritten Führungsplatte so gesetzt sind, daß die Adapterstifte (181) einerseits bei senkrechter Einführung in die Führungslöcher (180) der ersten Führungsplatte (176) mit ihrem sich konisch verjüngenden Ende auf jeden Fall noch in diese außer Raster befindlichen Führungslöcher (182a) der dritten Führungsplatte (178) treffen und andererseits bei weiterem Einführen durch diese außer Raster befindlichen Führungslöcher (182a) der dritten Führungsplatte (178) zwingend in die außer Raster befindlichen Führungslöcher (179a) der zweiten Führungsplatte (177) gelenkt werden, bei welchem Verfahren von dem Leiterplatten-Prüfgerät (197) diejenigen im Raster befindlichen Prüfkontakte festgestellt werden, die fehlerbehafteten im und/oder außer Raster befindlichen Prüfpunkten der zu prüfenden Leiterplatte (198) entsprechen, dadurch gekennzeichnet, daß einem Rechner (191) die Daten der Koordinaten aller Kontaktlöcher der zu prüfenden Leiterplatte (190, 198) zugeführt werden, daß mit dem Rechner (191) die Koordinaten der Bohrlöcher für die drei Führungsplatten (176, 177, 178) errechnet werden, daß dann in die drei Führungsplatten (176, 177, 178) die Löcher entsprechend den errechneten Koordinaten gebohrt werden, daß danach aus den drei Führungsplatten (176, 177, 178) der Adapter (175) montiert und die Adapterstifte (181) eingeführt werden, daß der Adapter (175) dann mit der zu prüfenden Leiterplatte (198) dem Leiterplatten-Prüfgerät (197) zugeführt wird, daß darauf die vom Leiterplatten-Prüfgerät (197) ermittelten Daten bzw. Koordinaten derjenigen im Raster befindlichen Prüfkontakte, die fehlerbehafteten im und/oder außer Raster befindlichen Prüfpunkten der zu prüfenden Leiterplatte (198) entsprechen, dem Rechner (191) übermittelt werden, daß mittels des Rechners (191) aufgrund dieser Daten bzw. Koordinaten die Daten bzw. Koordinaten der im und/oder außer Raster befindlichen Prüfpunkte der zu prüfenden Leiterplatte (198) ermittelt werden, und daß diese Daten bzw. Koordinaten mit einem Anzeigegerät (196) angezeigt und die fehlerhaften Prüfpunkte danach auf der zu prüfenden Leiterplatte (198) aufgesucht werden oder daß die fehlerbehafteten Prüfpunkte aufgrund dieser Daten bzw. Koordinaten mittels einer vorzugsweise optisch arbeitenden Fehleranzeige-Vorrichtung (195) direkt markiert werden.

## Revendication

Procédé pour le contrôle d'une carte imprimée (198) et pour l'indication des erreurs déterminées sur cette carte imprimée (198) au moyen d'un appareil de contrôle de cartes imprimées (197), avec utilisation d'un adaptateur (175) au moyen duquel des contacts de contrôle se trouvant en trame peuvent être reliés à des points de contrôle se trouvant en trame et/ou hors trame sur la carte imprimée à contrôler, par des tiges d'adaptateur dont l'extrémité tournée vers les points de contrôle s'effile en cône, ledit adaptateur présentant une première plaque de guidage et une seconde plaque de guidage ainsi qu'une troisième plaque de guidage se trouvant entre lesdites deux plaques, les trois plaques de guidage étant disposées parallèlement et à une distance fixe les unes par rapport aux autres et présentant des trous de guidage pour les tiges d'adaptateur, la première plaque de guidage présentant des trous de guidage se trouvant en trame et la deuxième plaque de guidage présentant des trous de guidage se trouvant en trame et/ou hors trame et coïncidant avec les points de contrôle de la carte imprimée à contrôler, et la troisième plaque de guidage présentant également des trous de guidage se trouvant en trame et/ou hors trame, et les trous de guidage (182a) hors trame de la troisième plaque de guidage étant disposés de manière que les tiges d'adaptateur (181), d'une part lors de l'introduction verticale dans les trous de guidage (180) de la première plaque de guidage (176), tombent par leur extrémité s'effilant en cône, dans tous les cas encore dans les trous de guidage (182a) hors trame de la troisième plaque de guidage (178) et, d'autre part, lors de l'introduction plus profonde, soient guidées par lesdits trous de guidage (182a) hors trame de la troisième plaque de guidage (178), obligatoirement dans les trous de guidage (179a) hors trame de la deuxième plaque de guidage (177), procédé dans lequel l'appareil de contrôle de cartes imprimées (197) détecte les contacts de contrôle se trouvant en trame qui correspondent aux points de contrôle entachés d'erreurs, en trame et/ou hors trame, de la carte imprimée (198) à contrôler, caractérisé par le fait que les données des coordonnées de tous les trous de contact de la carte imprimée (190, 198) à contrôler sont envoyées à un calculateur (191), qu'à l'aide du calculateur (191) sont calculées les coordonnées des trous de perçage pour les trois plaques de guidage (176, 177, 178), que les trous sont ensuite percés dans les trois plaques de guidage (176, 177, 178) en fonction des coordonnées calculées, que l'adaptateur (175) est ensuite monté à partir des trois plaques de guidage (176, 177, 178) et les tiges d'adaptateur (181) sont introduites, que l'adaptateur (175) est ensuite amené avec la carte imprimée (198) à contrôler à l'appareil de contrôle de cartes imprimées (197), qu'ensuite les données ou coordonnées déterminées par l'appareil de contrôle de cartes imprimées (197) en ce qui concerne les contacts de contrôle en trame correspondant aux points de contrôle entachés d'erreurs, en trame et/ou hors trame, de la carte imprimée (198) à contrôler sont transmises au calculateur (191), qu'à partir de ces données ou coordonnées, à l'aide du calculateur (191), sont déterminées les données ou coordonnées des points de contrôle en trame et/ou hors trame de la carte imprimée (198) à contrôler, que lesdites données ou coordonnées sont indiquées à l'aide d'un appareil indicateur (196) et les points de contrôle entachés d'erreurs sont ensuite recherchés sur la carte imprimée (198) à contrôler ou que les points de contrôle entachés d'erreurs sont, sur la base de ces données ou coordonnées, directement marqués à l'aide d'un dispositif indicateur d'erreurs (195) fonctionnant de préférence par voie optique.

## Claim

A method for testing a printed circuit board (198) and for indicating the faulty points detected on this printed circuit board (198) by means of a printed circuit board testing device (197) using an adapter (175) with which test contacts located on a grid can be connected to test points of a printed circuit board to be tested that are located on and/or off the grid by means of adapter pins of which the ends facing the test points are tapered conically, said adapter comprising a first and a second guide plate and a third guide plate between the two, all three being arranged parallel to and at a fixed distance apart from one another and having guide holes for the adapter pins, the first guide plate having guide holes located on the grid and the second guide plate having guide holes located on and/or off the grid which coincide with the test points of the printed circuit board to be tested, and the third guide plate likewise having guide holes located on and/or off the grid, the guide holes (182a) of the third guide plate that are located off the grid being so positioned that when the adapter pins (181) are guided vertically into the guide holes (180) of the first guide plate (176) their conically tapered ends can in each case still reach into said guide holes (182a) of the third guide plate (178) which are off the grid, and also, when they are inserted further through said guide holes (182a) of the third guide plate (178) that are located off the grid, they are necessarily guided into the guide holes (179a) of the second guide plate (177) that are located off the grid, whereby the printed circuit board testing device determines which of the test contacts located on the grid correspond to faulty test points of the printed circuit board (198) to be tested that are located on and/or off the grid, characterised in that the data of the coordinates of all the contact holes of the printed circuit board (190, 198) to be tested are supplied to a computer (191), in that the computer (191) calculates the coordinates of the bore holes for the three guide plates (176, 177, 178), in that the holes are then made in the three guide plates (176, 177, 178) according to the calculated coordinates, in that thereafter the adapter (175) is assembled from the three guide plates (176, 177, 178) and the adapter pins (181) are inserted, in that the adapter (175) is then introduced into the printed circuit board testing device (197) with the printed circuit board (198) to be tested, in that the data or coordinates determined by the printed circuit board testing device (197) of those test contacts located on the grid that correspond to faulty test points of the printed circuit board (198) to be tested that are located on and/or off the grid are then conveyed to the computer (191), in that on the basis of these data or coordinates the data or coordinates of the test points of the printed circuit board (198) to be tested that are located on and/or off the grid are determined by means of the computer (191), and in that these data or coordinates are indicated on a display device (196) and the faulty test points are then located on the printed circuit board (198) to be tested or, on the basis of the data or coordinates, the faulty test points are directly marked by means of a fault-indicating device (195) that preferably operates optically.

EP 0 222 345 B1

FIG. 1

EP 0 222 345 B1

FIG. 2

FIG. 3

FIG. 4

FIG. 5

FIG. 6

EP 0 222 345 B1

FIG. 7

FIG. 8

4

FIG. 9

MUSTERPLATTE

FIG. 10

DATEN-TRÄGER —192

190

LOCHBILD-EINGABE

DATEN-ABSPEICH.

DATEN-EINGABE

RECHNER

191

FEHLERKOORDINATEN der 2. FÜHRUNGSPLATTE

BOHRBILD für
1.,2.u.3.FÜHRUNGSPLATTE

196

195

NC
BOHRMASCHINE

193

FEHLERANZEIGE-VORRICHTUNG

BOHREN

BOHREN

MONITOR

FEHLERMARKIERUNG

BOHREN

176

FEHLERKOORD. der 1.FÜHRUNGSPLATTE

175

1. FÜHRUNGSPLATTE

MONTIEREN

ADAPTER
(ungeladen)

178

LEITERPLATTEN-PRÜFGERÄT

3.FÜHRUNGSPLATTE

AUTOMAT.
LADESYSTEM

194

197

177

198

2.FÜHRUNGSPLATTE

175

ADAPTER
(geladen)

zu prüfende
LEITERPLATTEN